(19) Europäisches Patentamt
European Patent Office
Office européen des brevets

(11) Veröffentlichungsnummer : **0 063 304**
**B1**

(12) # EUROPÄISCHE PATENTSCHRIFT

(45) Veröffentlichungstag der Patentschrift : **18.09.85**

(21) Anmeldenummer : **82102900.6**

(22) Anmeldetag : **05.04.82**

(51) Int. Cl.⁴ : **G 03 C 1/68**, G 03 C 1/71, C 08 L 33/06// G03F7/10, G03F7/26, H01L21/308, H01L21/467, H05K3/06

(54) **Durch Strahlung polymerisierbares Gemisch und daraus hergestelltes photopolymerisierbares Kopiermaterial.**

(30) Priorität : **13.04.81 DE 3114931**

(43) Veröffentlichungstag der Anmeldung : **27.10.82 Patentblatt 82/43**

(45) Bekanntmachung des Hinweises auf die Patenterteilung : **18.09.85 Patentblatt 85/38**

(84) Benannte Vertragsstaaten :
**AT BE CH DE FR GB IT LI NL SE**

(56) Entgegenhaltungen :
**EP-A- 0 002 040**
**DE-A- 2 736 058**
**DE-A- 2 747 947**
**DE-A- 2 841 880**
**DE-A- 2 849 996**
**DE-B- 2 450 381**

(73) Patentinhaber : **HOECHST AKTIENGESELLSCHAFT**
**Postfach 80 03 20**
**D-6230 Frankfurt am Main 80 (DE)**

(72) Erfinder : **Herwig, Walter, Dr.**
**Hasenpfad 7**
**D-6232 Bad Soden 2 (DE)**
Erfinder : **Decker, Rudolf**
**Wormser Strasse 10**
**D-6501 Bodenheim (DE)**
Erfinder : **Sikora, Helga**
**Bunsenstrasse 7F**
**D-6200 Wiesbaden (DE)**
Erfinder : **Erbes, Kurt**
**Friedrich-Stolz-Strasse**
**D-6093 Flörsheim 3 (DE)**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



Jouve, 18, rue St-Denis, 75001 Paris, France

**Beschreibung**

Die Erfindung betrifft ein durch Strahlung polymerisierbares Gemisch, das als wesentliche Bestandteile

a) eine Verbindung mit mindestens zwei endständigen ethylenisch ungesättigten Gruppen, die durch radikalisch initiierte Additionskettenpolymerisation ein vernetztes Polymerisat zu bilden vermag,

b) ein polymeres Bindemittel und

c) einen durch Strahlung aktivierbaren Polymerisationsinitiator

enthält und das bevorzugt als trocken übertragbares Photoresistmaterial zur Herstellung von Lötstopmasken verwendet wird.

Leiterplatten mit ein- und doppelseitigem, vor allem aber durchkontaktiertem Aufbau, werden vor dem Löten mit einer Lötstopmaske versehen. Durch das Aufbringen solcher Masken bleiben nur die Lötaugen offen, wodurch Zinn beim Löten eingespart wird. Auch wird beim Lötvorgang ein Teil der Lötwärme vom Werkstück ferngehalten, so daß die beim Bestücken der Leiterplatten eingesetzten hitzeempfindlichen Bauelemente während des Lötens nicht geschädigt werden. Nicht zuletzt aber erfüllen Lötstopmasken die wichtige Funktion, alle Bereiche des Schaltbildes abzudecken, die mit dem Lötmetall nicht in Kontakt treten dürfen, um beispielsweise zu verhindern, daß sich für ein Leitersystem tödliche Leitungsbrücken zwischen den einzelnen Leiterbahnen bilden können.

Um diesen recht komplexen Forderungen zu genügen, kamen in der Vergangenheit unterschiedliche Verfahren und Produkte unterschiedlicher Darreichungsform zur Anwendung.

Aus den vorangestellten Ausführungen erhellt, daß Lötstopmasken ein an den vorgegebenen Leiterbahnen orientiertes Bildmuster aufweisen müssen. Weit verbreitet in der Praxis ist der Brauch, Lötstopmasken nach der Technik des Siebdruckes zu applizieren ; nach dieser Methode lassen sich auch Masken größerer Schichtdicken aufbringen, womit vor allem sichergestellt werden kann, daß die Leiterbahnen gut umhüllt und eingebettet werden.

Diese nach dem Siebdruckverfahren hergestellten Masken stoßen an eine im System begründete Grenze, nämlich dann, wenn die Abstände der Leiterbahnen verringert werden, so daß die relativ groben Bildstrukturen des Siebdruckes der Feinleitertechnik nicht mehr gerecht werden können.

In neuerer Zeit wurden deshalb in zunehmenden Maße Lötstopmasken nach der Photoresisttechnik hergestellt. Ebenso wie bei der Herstellung gedruckter Schaltungen werden hier thermoplastische photopolymerisierbare Schichten unter Druck und Erwärmen auf die Leiterplatte laminiert und bildmäßig an den Stellen durch Belichten gehärtet, an denen die Leiterplatte abgedeckt werden soll. Durch Auswaschen der unbelichteten Schichtstellen erhält man die Lötstopmaske. Dieses Verfahren ermöglicht höhere Bildauflösungen als das Siebdruckverfahren.

Geeignete Materialien dieser Art sind z. B. in der DE-A-2 747 947 beschrieben. Es handelt sich hierbei um photopolymerisierbare Schichten, die zur Verbesserung der Flammwidrigkeit eine bestimmte Menge gebundenes Halogen enthalten. Ein ähnliches Material ist in der EP-A-15 004 beschrieben, das sich trocken durch mechanisches Trennen von belichteten und unbelichteten Schichtbereichen entwickeln läßt (« peel-apart-Verfahren »). Schließlich wird in der EP-A-2040 ein für den gleichen Zweck bestimmtes lichthärtbares Material beschrieben, bei dem als lichtempfindliche Verbindungen nicht näher bezeichnete lichtempfindliche Epoxyharze verwendet werden.

Die für diesen Zweck bekannten und verwendeten photopolymerisierbaren Gemische werden trocken und unter Erwärmen auf die zu markierende Leiterplatte übertragen und müssen deshalb notwendig thermoplastisch sein. Diese Eigenschaft ist jedoch nachteilig bei der Verwendung als Lötstopmasken, da diese Temperaturen oberhalb 200 °C ohne Zersetzung und ohne zu starkes Erweichen oder gar Schmelzen überstehen müssen. Zwar wird die Photopolymerschicht an den belichteten Stellen durch vernetzende Polymerisation wesentlich gehärtet, und diese Lichthärtung läßt sich durch Nachbelichten der entwickelten Bildschablone in bekannter Weise noch verstärken. Es bleibt jedoch grundsätzlich eine Erweichungstendenz beim Erwärmen von allen bekannten photopolymerisierbaren Schichten.

Aufgabe der Erfindung war es, zur Herstellung von trocken übertragbaren Photoresistschichten geeignete photopolymerisierbare Gemische vorzuschlagen, die bei der Übertragung die erforderliche Thermoplastizität aufweisen, die aber im belichteten und entwickelten Zustand unter den Bedingungen des Lötprozesses die erforderliche Beständigkeit aufweisen.

Erfindungsgemäß wird ein durch Strahlung polymerisierbares Gemisch vorgeschlagen, das

a) eine Verbindung mit mindestens zwei endständigen ethylenisch ungesättigten Gruppen, die durch radikalisch initiierte Additionskettenpolymerisation ein vernetztes Polymerisat zu bilden vermag,

b) ein polymeres Bindemittel und

c) einen durch Strahlung aktivierbaren Polymerisationsinitiator

enthält.

Das erfindungsgemäße Gemisch ist dadurch gekennzeichnet, daß es zusätzlich

d) eine Verbindung mit zwei Epoxygruppen im Molekül und einem Molekulargewicht von nicht mehr als 1 500, vorzugsweise unterhalb 1 000, enthält.

Als aktinische Strahlung, gegenüber der das erfindungsgemäße Gemisch empfindlich ist, kommt

jede elektromagnetische Strahlung in Betracht, deren Energie zur Anregung eines geeigneten Polymerisationsinitiators ausreicht. Geeignet ist insbesondere sichtbares und ultraviolettes Licht, Röntgen-, γ- und Elektronenstrahlung. Auch Laserstrahlung im sichtbaren und UV-Bereich kann verwendet werden. Bevorzugt wird kurzwelliges sichtbares und nahes UV-Licht.

Als Bisepoxide sind insbesondere Bisglycidylether von zweiwertigen Alkoholen und Phenolen, z. B. von Bisphenol A, von Polyethylenglykol- und Polypropylenglykolethern des Bisphenols A, von Butan-1,4-diol, Hexan-1,6-diol, Polyethylenglykol, Polypropylenglykol oder Polytetrahydrofuran geeignet. Auch Bisglycidylether von dreiwertigen Alkoholen, z. B. von Glycerin, können verwendet werden. Die Bisepoxide werden dem Gemisch gewöhnlich in einer Menge von etwa 1,5 bis 10, vorzugsweise 2 bis 6 Gew.-%, bezogen auf die nichtflüchtigen Bestandteile des Gemischs, zugesetzt.

Bevorzugt werden Bisepoxide der allgemeinen Formel

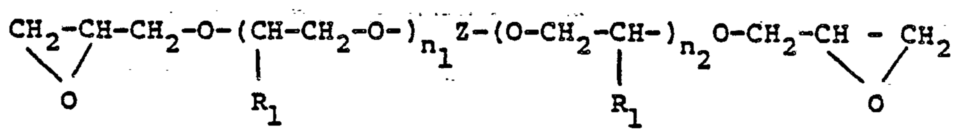

verwendet, worin

Z eine Alkylen- oder Hydroxyalkylengruppe mit 2 bis 6 Kohlenstoffatomen oder die Gruppe

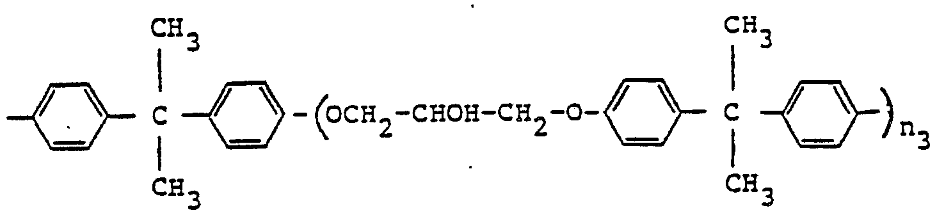

$R_1$ ein Wasserstoffatom oder eine Methylgruppe,

$n_1$ und $n_2$ Zahlen von 0 bis 10, vorzugsweise von 0 bis 5, und

$n_3$ 0 oder eine Zahl von 1 bis 4, vorzugsweise 0 oder 1,

bedeuten.

Als polymerisierbare Verbindungen werden im allgemeinen Ester der Acryl- oder Methacrylsäure mit mehrwertigen, vorzugsweise primären, Alkoholen verwendet. Der Alkohol sollte 2 bis etwa 4 Hydroxygruppen enthalten, da durch mehrfach ungesättigte Verbindungen die erwünschte Vernetzungswirkung erreicht wird. In untergeordneter Menge können auch Ester von einwertigen oder höherwertigen Alkoholen in Gemisch enthalten sein. Beispiele für geeignete mehrwertige Alkohole sind Ethylenglykol, Propylenglykol, Butandiol-1,4, Butandiol-1,3, Diethylenglykol, Triethylenglykol, Polyethylenglykole mit Molekulargewischten von etwa 200 bis 1 000, Neopentylglykol, Trimethylolethan und -propan, Pentaerythrit und Bisphenol-A-bis-hydroxyethylether. Es sind ferner die niedermolekularen, Urethangruppen enthaltenden Bis-acrylate und Bis-methacrylate geeignet, die durch Umsetzen von 2 Mol Hydroxyalkylacrylat oder -methacrylat mit 1 Mol eines aliphatischen oder cycloaliphatischen Diisocyanats, z. B. 2,2,4-Trimethyl-hexamethylendiisocyanat, erhalten werden. Derartige Urethangruppen enthaltende Monomere sind in der US-A-4 088 498 beschrieben.

Mit Vorteil werden Gemische unterschiedlicher Monomerer verwendet. Dabei hat es sich besonders bewährt, Monomere der oben angegebenen Art mit höhermolekularen, Urethanen mit Einheiten der allgemeinen Formel

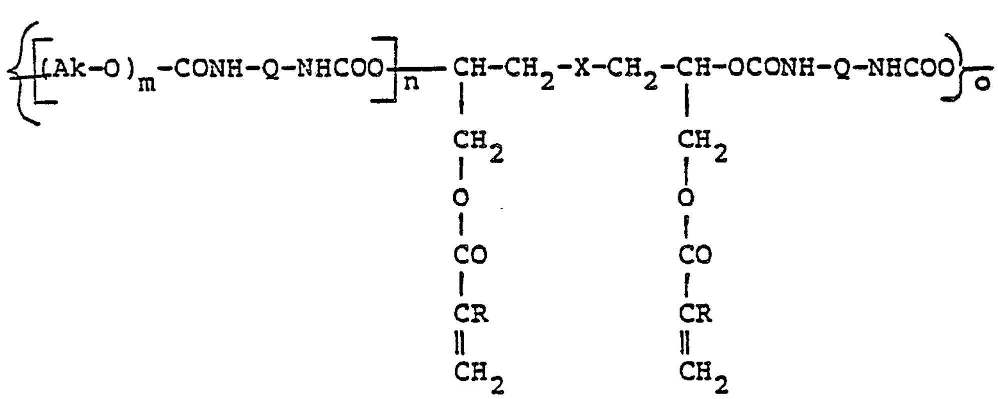

zu kombinieren, wobei

Q ein zweiwertiger ein- oder zweikerniger aromatischer Rest, der unsubstituiert oder durch niedere Alkylgruppen substituiert ist und der als Bindeglied eine niedere Alkylengruppe enthalten kann,

X eine der Gruppen —O—Ph—X'—Ph—O— und —OOC—$(CH_2)_y$—COO—, wobei Ph eine gegebenenfalls substituierte Phenylengruppe, X' eine Alkylengruppe mit 1-4 Kohlenstoffatomen und y eine Zahl von 2 bis 12 ist,

R ein Wasserstoffatom oder eine Methylgruppe,

Ak ein Alkylenrest mit 2-4 Kohlenstoffatomen,

m eine Zahl von 4 bis 50,

n eine Zahl von 1 bis 6 und

o eine Zahl von 4 bis 20 ist.

Die Herstellung dieser Polyetheresterurethane erfolgt in bekannter Weise durch Umsetzen von oligomeren Diisocyanaten der Formel

$$OCN—Q—[NHCOO—(AkO)_mCONH—Q—)_nNCO$$

mit Bis-acrylsäureester-diolen der Formel

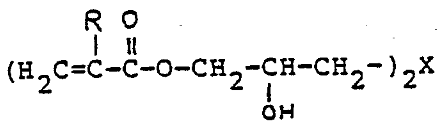

Die Herstellung und Verwendung dieser Verbindungen ist in der EP-A-48 913 beschrieben.

Diese Polyurethane haben im allgemeinen reduzierte spezifische Viskositäten (RSV), gemessen an 1 %igen Lösungen in Dimethylformamid bei 25 °C, von etwa 0,15 bis 1,4 dl/g.

Bevorzugt werden Produkte mit RSV-Werten im Bereich von 0,2 bis 0,9 dl/g.

Bevorzugte mittlere Werte von m liegen bei 8-20, von n bei 2-4, von o bei 5-12 und von y bei 2-6. X' ist eine Alkylengruppe, in der die freien Valenzen bevorzugt an einem C-Atom stehen. Bevorzugte Gruppen sind Methylen-, 1,1-Ethylen- und 2,2-Propylengruppen. R ist vorzugsweise eine Methylgruppe.

Die Gesamtmenge an polymerisierbaren Verbindungen liegt im allgemeinen zwischen 20 und 50, vorzugsweise 25 bis 45, Gew.-%, bezogen auf die nichtflüchtigen Anteile des Gemischs. Von dieser Menge können 2 bis 20, bevorzugt 5 bis 10 Gew.-%, auf die gleiche Basis bezogen, aus Polyurethanen der oben angegebenen allgemeinen Formel bestehen.

Die erfindungsgemäßen Gemische enthalten ferner ein polymeres, bevorzugt gesättigtes Bindemittel. Vorzugsweise werden wasserunlösliche, im wäßrig-alkalischen Lösungen lösliche oder mindestens quellbare Bindemittel verwendet. Als alkalilöslichmachende Gruppen können die Bindemittel Phosphonsäure-, Sulfonsäure-, Sulfonamid-, Carbonsäureanhydrid- und bevorzugt Carboxylgruppen enthalten. Bevorzugte Bindemittel sind Mischpolymerisate aus Methacrylsäure und Alkylmethacrylaten und gegebenenfalls noch Styrol oder anderen Comonomeren, wie sie in den DE-A-2 064 080 und 2 363 806 beschrieben sind. Die Bindemittel werden in einer Menge von 40 bis 80, vorzugsweise 50 bis 70 Gew.-%, der nichtflüchtigen Bestandteile des Gemischs verwendet.

Als Photoinitiatoren in dem erfindungsgemäßen Gemisch können eine Vielzahl von Substanzen Verwendung finden. Beispiele sind Acridinderivate, z. B. 9-Phenyl-acridin, 9-p-Methoxy-phenyl-acridin, 9-Acetylamino-acridin, Benz(a)acridin ; Phenazinderivate, z. B. 9,10-Dimethylbenz(a)phenazin, 9-Methylbenz(a)phenazin, 10-Methoxybenz(a)-phenazin, Chinoxalinderivate, z. B. 6,4',4''-Trimethoxy-2,3-diphenylchinoxalin, 4', 4''-Dimethoxy-2,3-diphenyl-5-azachinoxalin oder Chinazolinderivate. Die Acridin-, Phenazin- und Chinoxalinderivate werden bevorzugt. Die Photoinitiatoren werden allgemein in einer Menge von 0,01 bis 10, vorzugsweise von 0,05 bis 2 Gew.-% verwendet.

Vorzugsweise enthalten die Gemische mindestens einen Farbstoff, um die entwickelte Resistschablone besser sichtbar zu machen. Dabei wird mit Vorteil eine Kombination von mindestens zwei Farbstoffen verwendet, von denen der eine bei Bestrahlung seine Farbe ändert und bei Temperaturen oberhalb 200 °C zerstört, d. h. farblos wird. Der andere Farbstoff soll sowohl die Bestrahlung als auch Temperaturen oberhalb 200 °C ohne Veränderung überstehen. Er soll die Lötstopmaske während des Lötens und danach deutlich sichtbar machen.

Als Farbstoffe, die bei Belichtung einen Farbumschlag zeigen, sind z. B. Triphenylmethanfarbstoffe und bestimmte Azofarbstoffe, wie sie in der DE-A-2 807 933 (= US-A-4 241 166) beschrieben sind, geeignet.

Als licht- und hitzebeständige Farbstoffe sind Oxazolonfarbstoffe, z. B. ein Farbstoff der Formel

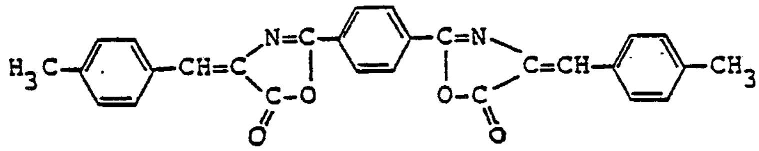

oder Anthrachinonfarbstoffe, z. B. das 1,4-Bis-(4-tert. butoxy-phenylamino)-5,8-dihydroxy-anthrachinon, geeignet.

Die erfindungsgemäßen Gemische können außer Monomeren, Bindemitteln, Photoinitiatoren und

Farbstoffen noch eine Reihe weiterer üblicher Zusätze enthalten, z. B. Inhibitoren zur Verhinderung der thermischen Polymerisation der Monomeren, Wasserstoffdonatoren, sensitometrische Regler, Pigmente und Weichmacher.

Das erfindungsgemäße Gemisch wird in bekannter Weise zu einem Trockenresistmaterial verarbeitet. Im allgemeinen wird eine Lösung des Gemischs in einem Lösemittel auf einen geeigneten Schichtträger, z. B. eine Polyesterfolie, aufgebracht und getrocknet. Die Schichtdicke der Resistschicht kann etwa 10 bis 150, vorzugsweise 20 bis 120 µm betragen. Die freie Oberfläche der Schicht wird vorzugsweise mit einer Deckfolie, z. B. aus Polyethylen oder Polypropylen, abgedeckt. Das fertige Laminat kann als Großrolle gespeichert und bei Bedarf zu Resistrollen beliebiger Breite zerschnitten werden.

Die Folien lassen sich mit in der Trocknresisttechnik üblichen Geräten verarbeiten. In einer handelsüblichen Laminiervorrichtung wird die Deckfolie abgezogen und die Lötstopresistschicht auf die zu schützende, z. B. mit metallisierten Bohrungen versehene, Leiterplatte laminiert. Die so präparierte Platte wird dann durch eine Vorlage belichtet, die die Teile der Platte vor der Bestrahlung schützt, die für den Lötvorgang freibleiben müssen.

Entwickelt werden die von der Trägerfolie befreiten Resistschichten in bekannter Weise. Als Entwickler sind wäßrige, vorzugsweise wäßrig-alkalische Lösungen, z. B. von Alkaliphosphaten, -carbonaten oder -silikaten, geeignet, denen gegebenenfalls kleine Mengen, z. B. bis zu 10 Gew.-% an mit Wasser mischbaren organischen Lösungsmitteln oder Netzmiteln zugesetzt werden können.

Fertig präparierte, nach den eben beschriebenen Verfahrensschritten abgedeckte Leiterplatten müssen nun vor dem Lötprozeß einer Temperaturbehandlung unterzogen werden. Es wird angenommen, daß dabei Teile des Bindemittels mit dem Epoxid zu einem interpenetrierenden Netzwerk reagieren, das die guten mechanischen, thermischen und chemischen Eigenschaften der Lötstopmasken bewirkt. Diese thermische Behandlung erfolgt im allgemeinen zwischen 80 °C und 150 °C, bei ungefähren Behandlungszeiten von 10 bis 40 Minuten.

Die lötbereite Platte kann mit elektronischen Bauelementen bestückt werden, deren Anschlußstücke über die entsprechenden Leitungen der Schaltung in den Bereichen, die im Entwicklungsprozeß freigelegt wurden, gebogen werden.

Die Leitungsseite der Platte kann dann mit einem passenden, handelsüblichen Flußmittel behandelt und über eine handelsübliche Schwall-Lötmaschine der Schwall-Lötung unterworfen werden.

Als Lötmittel dienen bekannte eutektische Gemische, die Löttemperaturen von etwa 230° bis 260 °C gestatten. Ein bekanntes Gemisch enthält beispielsweise 63 Gew.-% Zinn und 37 Gew.-% Blei.

Auch für Verfahren, bei denen doppelseitige, durchkontaktierte Leiterplatten durch Eintauchen in flüssige Metallbäder gelötet werden, lassen sich die erfindungsgemäßen Lötstopmasken mit Erfolg einsetzen.

Die erfindungsgemäßen Gemische ergeben Lötstopresistschichten, die sich durch hohe Flexibilität und mechanische Festigkeit im unbelichteten und belichteten Zustand und durch eine hohe Temperaturresistenz im belichteten und nachgehärteten Zustand auszeichnen. Die photopolymerisierbaren Schichten weisen in Kombination mit den bevorzugten Photoinitiatoren eine hohe Lichtempfindlichkeit auf und ergeben auch bei hoher Schichtdicke eine gute Durchhärtung bzw. Durchvernetzung. Die belichteten Schichten lassen sich auch bei Schichtdicken oberhalb 100 µm einwandfrei und vollständig mit wäßrig-alkalischen Lösungen entwickeln.

Die belichteten und entwickelten Schichten lassen sich ohne übermäßige Beeinträchtigung der Flexibilität der Maske oder ihrer Haftung auf der Unterlage und ohne Veränderung der Lage und Dimensionen der durch Entwicklung freigelegten Bereichte thermisch härten. Die gehärteten Masken sind gegenüber atmosphärischen, thermischen und chemischen Einflüssen über längere Zeiträume beständig. Nach dem Belichten der Resistschicht wird bereits ein kontrastreiches Bild in der Schicht erhalten. Die lichtgehärtete Maske behält ihre kontrastreiche Färbung auch nach dem Löten bei. Die aus den erfindungsgmäßen Gemischen erhaltenen Lötstopmasken eignen sich in besonderem Maße dazu, empfindliche elektronische Leiterstrukturen vor atmosphärischen Angriffen wirksam und dauerhaft zu schützen.

Die folgenden Beispiele erläutern einzelne Ausführungsformen des erfindungsgemäßen Gemischs. Wenn nichts anderes angegeben ist, sind Prozentzahlen und Mengen verhältnisse in Gewichtseinheiten zu verstehen. Gewichtsteile (Gt) und Volumenteile (Vt) stehen im Verhältnis von g zu ml.

### Beispiel 1

Eine Lösung wurde hergestellt aus :

26 Gt eines Terpolymerisates aus n-Hexylmethacrylat, Methacrylsäure und Styrol (60 : 30 : 10) mit einem mittleren Molgewicht von ca. 35 000 und der Säurezahl 195,
12,8 Gt Polyethylenglykol-400-dimethacrylat,
3,2 Gt des unten beschriebenen Elastomeren,
1,2 Gt 2,2-Bis-(4-glycidoxy-phenyl)propan,
0,2 Gt 9-Phenyl-acridin,
0,02 Gt 2,4,6-Trinitro-2′-acetylamino-4′-diethylamino-5′-methyl-azobenzol und

0,06 Gt 1,4-Bis-(4-tert.butoxy-phenylamino)-anthrachinon in
107,5 Gt Butanon und
6,0 Gt Ethanol.

Das verwendete Elastomere wurde wie folgt hergestellt :

A. In einem 1-Liter-Vierhalskolben, ausgerüstet mit Rührer, Thermometer, Rückflußkühler und Trockenrohr, wurden 426 Gt Glycidylmethacrylat und 216 Gt Adipinsäure durch Rühren vermischt und nach Zugabe von 19,7 Gt p-Methoxy-phenol und 6,4 Gt Benzyl-triethylammoniumchlorid vorsichtig auf eine Innentemperatur von 80 °C erhitzt. Nach ca. 2 Stunden wurde eine klare Lösung erhalten, die noch 14 Stunden bei 80 °C gehalten wurde. Der Gehalt an freiem Glycidylmethacrylat war nach dieser Zeit kleiner als 0,5 %.

B. In einen mit Rührer, Thermometer, Tropftrichter, Kühler und Trockenrohr bestückten 1-Liter-Vierhalskolben wurden 143 Gt eines oligomeren Diisocyanats der Formel

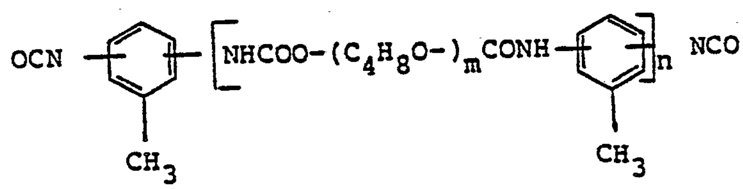

mit einem mittleren Molekulargewicht um 2 000 und einem Isocyanatgruppengehalt von 4,1 Gew.-% (Adiprene L 100, Warenzeichen), gelöst in 300 Vt Methylethylketon, gegeben und mit 0,87 Gt Benzochinon und 0,85 Vt einer Lösung versetzt, die durch Lösen von 6,3 Gt Eisen-III-acetylacetonat und 0,45 Gt Triethylamin in Methylethylketon und Auffüllen mit Methylethylketon auf 100 Vt hergestellt wurde. In den Tropftrichter wurde eine Lösung von 31, 33 Gt des nach A erhaltenen Umsetzungsproduktes in 300 Vt Methylethylketon gefüllt und der auf 70 °C erhitzten und gerührten Lösung im Kolben innerhalb 40 Minuten zugetropft. Nach zweistündigem Nachrühren bei 30 °C wurden dem klaren Reaktionsgemisch 10 Vt Ethanol zugesetzt. Durch Abdestillieren des Lösemittels wurde aus der viskosen Lösung eine nicht klebende kautschukartige Masse erhalten, die in zahlreichen organischen Lösungsmitteln, wie Tetrahydrofuran, Aceton oder Toluol klar löslich war. Die reduzierte spezifische Viskosität des Produkts betrug 0,72 dl/g (gemessen an einer 1 %igen Lösung in Dimethylformamid bei 25 °C).

Mit einer Lösung dieser Zusammensetzung wurde eine 110 cm breite Bahn einer biaxial verstreckten und thermofixierten Polyethylenterephthalatfolie der Stärke 25 µm mittels einer Schlitzdüse kontinuierlich beschichtet. Nach Durchlaufen einer Trockenzone hatte die Resistschicht eine Dicke von 70 µm und wurde mit einer Polypropylenfolie abgedeckt. Die so gefertigte Trockenresistfolie wurde auf einer Großrolle gespeichert. Die Großrolle wurde anschliessend mittels eines Rollenschneiders zu handlichen Resistrollen einer Breite von 45 cm und einer Bahnlänge von 50 m zerschnittten. Durch Einstellen einer optimalen Wickelspannung wurde gewährleistet, daß die Rolle Lage für Lage gleichmäßig über dem Trägerkern aufgebaut saß und seitlich nicht abrutschte, d. h. nicht teleskopierte.

Die Schnittkanten dieser Rollen sind, gelagert bei 20 °C, auch nach Monaten unverändert und völlig frei von zur Verklebung führenden Resistaustritten. Nach über drei Wochen Lagerzeit bei 40 °C im Trockenschrank sind die Schnittkanten noch klebefrei.

Für die Laminierversuche dienten mit einer 35 µm dicken Kupferfolie kaschierte Epoxidharzglasgewebe von 24 × 36 cm Größe. Auf diesen Platten wurde mittels eines handelsüblichen Negativtrockenresists und einer ein Schaltbild tragenden Belichtungsmaske durch Belichten in bekannter Weise ein Leiterbahnenbild erzeugt mit Leiterbahnenbreiten von minimal 200 µm und Leiterbahnenabständen von minimal 180 µm. Die nach dem Entwickeln freigelegten Leiterbahnen wurden dann wie folgt galvanisch verstärkt :

1. 40 Minuten in einem Kupferelektrolytbad der Firma Schlötter, Geislingen/Steige, Typ « Glanzkupfer-Bad » (Warenzeichen)

Stromdichte 2,5 A/dm$^2$
Metallaufbau ca. 20 µm

2. 15 Minuten in einem Blei-Zinnbad der Firma Schlötter, Geislingen/Steige, Typ « LA » (Warenzeichen)

Stromdichte 1,0 A/dm$^2$
Metallaufbau 10 µm

Nach Entfernen der Photoresistschablone (Strippen) und Wegätzen des Basiskupfers wurden Testplatten mit ca. 65 µm starken Leiterbahnen mit einer verzinnten Oberfläche erhalten, die im folgenden als « Sn-Platten » bezeichnet werden.

In einem weiteren Versuch wurden Platten hergestellt, bei denen nur die zusätzliche Kupferverstärkung vorgenommen und das Basiskupfer weggeätzt wurde. Diese Platten werden im folgenden als « Cu-Platten » bezeichnet.

Auf diese Platten wurde die 70 µm starke Lötstopresistschicht mit einer handelsüblichen Laminiervorrichtung bei 120 °C laminiert.

Dann wurden die Platten durch eine Belichtungsvorlage, die die zu lötenden Augen und Löcher abdeckte, mit einem handelsüblichen Belichtungsgerät mit 5 kW-Metallhalogenid-Lampe 12 Sekunden belichtet, dann in einem handelsüblichen Sprühprocessor 2 Minuten mit 0,8 %iger Sodalösung entwickelt und trocken geblasen. Die so präparierten Leiterplatten wurden dann in einem Trockenschrank 20 Minuten bei 120 °C gehärtet. Die abgekühlten Platten wurden anschließend mit dem wasserlöslichen Flußmittel ALPHA 709 (Karenzeichen) der Firma Alpha Grillo benetzt und sodann mit einer Geschwindigkeit von 0,25 m/min über ein handelsübliches Lötschwallbad von 240 °C geführt.

Nach diesem Verfahren wurden Platten mit staubtrockener, sehr schlag- und kratzfester Oberfläche erhalten. Auch schmale Leiterzüge sind von der gehärteten Lötstopschicht fest umhüllt, präparierte Schliffbilder zeigen keine Fehlstellen oder Lufteinschlüsse an Ober- und Unterkanten der Leiterbahnen.

Bei den Sn-Platten bildeten sich runzelartige Oberflächen (« Orangenschalen ») auf der Lötstopmaske aus, bedingt durch ein Anschmelzen der Zinnoberfläche beim Löten. Aber auch in diesen Fällen wird eine absolut sichere und fehlerfreie Haftung der Lötstopmaske erzielt.

Bei den Cu-Platten wurde wie folgt verfahren :

Die Schritte Laminieren, Belichten, Entwickeln und Nachhärten wurden ebenso wie oben durchgeführt. Danach wurden die freigelegten Löcher der Leiterplatten mit Hilfe des sogenannten « Hot-Air-Levelling »-Verfahrens mit einer dünnen Blei-Zinn-Schicht versehen. Bei diesem Hot-Air-Levelling oder beim Heißverzinnen wurden die Leiterplatten in ein 250 °C heißes Blei-Zinn-Bad eingetaucht und während des Herausziehens mit ebenso heißer Luft abgeblasen. Dabei wurden eventuell verschlossene Löcher freigeblasen. In den Löchern und um diese herum blieb eine hauchdünne Blei-Zinn-Schicht als Korrosionsschutz zurück. Die Lötstopmaske zeigte nach dieser Behandlung keinerlei Beeinträchtigung.

## Beispiel 2

Mit der in Beispiel 1 beschriebenen Lösung wurde in analoger Weise eine 100 um dicke Resistschicht hergestellt, auf Leiterplatten laminiert, belichtet, entwickelt und nachgehärtet. Die so präparierten Platten zeigten nach dem Löten keinerlei Runzeloberflächen.

## Beispiel 3

Es wurde wie in Beispiel 1 gearbeitet, wobei anstelle des dort verwendeten Elastomeren 3,2 Gt des unten beschriebenen Elastomeren verwendet wurden. Mit dieser Lösung wurde wie in Beispiel 1 eine Trockenresistfolie hergestellt, diese laminiert, belichtet und entwickelt. Bei allen Verarbeitungsschritten wurden praktisch die gleichen Ergebnisse wie in Beispiel 1 erhalten. Das verwendete elastomere Polyurethan wurde wie folgt hergestellt :

177 Gt des in Beispiel 1 unter B angegebenen oligomeren Diisocyanats wurden in 250 Vt Methylethylketon unter Zugabe von 1 Gt 1,4-Benzochinon, 0,05 Gt Eisen-III-acetylacetonat und 2 Vt einer 1 %igen Lösung von Triethylamin in Methylethylketon in einem 1-Liter-Drei-halskolben, versehen mit Thermometer, Tropftrichter, Kühler, Trockenrohr und Magnetrührer, vorgelegt.

Zu dieser Lösung wurde nach Erhitzen auf 60 °C eine Lösung von 45,3 Gt 2,2-Bis [4-(2-methacryloyloxy-propoxy)-phenyl]-propan, Handelsprodukt, (C theor. : 67,97 % ; C gef. : 67,9 % ; H theor. : 7,03 ; H gef. : 7,1 ; OH-Zahl theor. : 219 ; OH Zahl gef. : 216 ; Br-Zahl theor. : 62,5 ; Br-Zahl gef. : 65) in 150 Vt Methylethylketon innerhalb von 30 Minuten zugetropft und das Reaktionsprodukt 2 Stunden bei 62-70 °C gehalten ; danach wurden 5 Vt Alkohol zugesetzt. Durch Abdestillieren des Lösemittels wurde ein trockener, elastischer Kautschuk, rücklöslich in Methylethylketon und anderen organischen Lösemitteln, wie Toluol und Tetrahydrofuran, erhalten. Das Produkt hatte eine reduzierte spezifische Viskosität von 0,68 dl/g (gemessen an einer 1 %igen Lösung von Dimethylformamid bei 25 °C).

## Beispiele 4 bis 7

In der folgenden Tabelle sind vier Beispiele summiert, die sich in der technischen Durchführung nicht von den Beispielen 1 und 2 unterscheiden, jedoch rezeptuelle Unterschiede besitzen. Dadurch bedingte Eigenschafts-varianten der Resists sind in der Tabelle stichwortartig notiert. Die Mengen sind in Gewichtsteilen angegeben. Als Bindemittel wurden in allen vier Beispielen 26 Gt des in Beispiel 1 angegebenen Terpolymerisats verwendet. Es wurden ferner die in Beispiel 1 angegebenen Farbstoffe in den gleichen Mengen wie dort zugesetzt.

Siehe Tabelle Seite 8 f.)

Tabelle

| Beispiel | niedermolekulares Monomeres | Menge | Polyurethanmonomeres | Menge | Bis-epoxid | Menge | 9-Phenylacridin | Bemerkungen |
|---|---|---|---|---|---|---|---|---|
| 4 | Bis-urethan-dimeth-acrylat *) | 18 | wie Beispiel 1 | 3,2 | wie Beispiel 1 | 1,2 | 0,2 | gute Haftung auf Metall |
| 5 | Polypropylenglykoldimethacrylat | 14 | " | 3,2 | " | 1,2 | 0,2 | vergleichbar mit Beispiel 1 hohe Lichtempfindlichkeit |
| 6 | Polyethylenglykol-400-dimethacrylat | 12,8 | " | 3,2 | **) | 1,5 | 0,2 | Flexible Resistschicht Orangenschaleneffekt |
| 7 | " | 12,8 | " | 3,2 | wie Beispiel 1 | 1,2 | 0,1 | Lange Lagerstabilität, etwas geringere Lichtempfindlichkeit |

*) Hergestellt aus 1 Mol 2,2,4-Trimethylhexamethylendiisocyanat und 2 Mol β-Hydroxy-ethylmethacrylat

**) Reaktionsprodukt aus Bisphenol A und Epichlorhydrin mit dem Epoxyäquivalentgewicht 450

**Patentansprüche**

1. Durch Strahlung polymerisierbares Gemisch, enthaltend
a) eine Verbindung mit mindestens zwei endständigen ethylenisch ungesättigten Gruppen, die durch radikalisch initiierte Additionskettenpolymerisation ein vernetztes Polymerisat zu bilden vermag,
b) ein polymeres Bindemittel und
c) einen durch Strahlung aktivierbaren Polymerisationsinitiator
dadurch gekennzeichnet, daß es zusätzlich
d) eine Verbindung mit zwei Epoxygruppen im Molekül und einem Molekulargewicht von nicht mehr als 1 500 enthält.

2. Durch Strahlung polymerisierbares Gemisch, dadurch gekennzeichnet, daß die Verbindung mit zei Epoxygruppen in einer Menge von 1,5 bis 10 Gew.-% darin enthalten ist.

3. Durch Strahlung polymerisierbares Gemisch nach Anspruch 1, dadurch gekennzeichnet, daß die Verbindung mit zwei Epoxygruppen ein Bisglycidylether eines zweiwertigen Alkohols oder Phenols ist.

4. Durch Strahlung polymerisierbares Gemisch nach Anspruch 3, dadurch gekennzeichnet, daß die Verbindung mit zwei Epoxygruppen der allgemeinen Formel

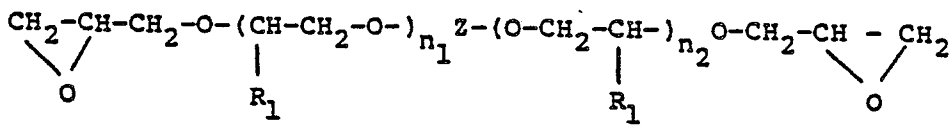

entspricht, worin
Z eine Alkylen- oder Hydroxyalkylengruppe mit 2 bis 6 Kohlenstoffatomen oder die Gruppe

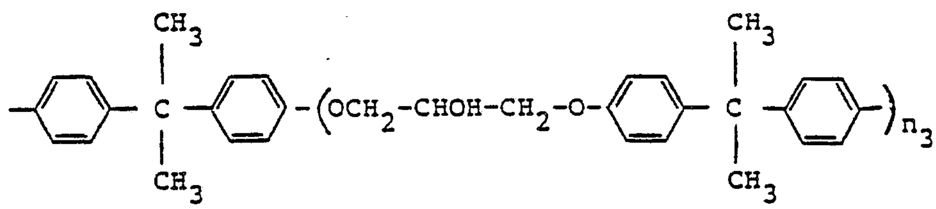

$R_1$ ein Wasserstoffatom oder eine Methylgruppe,
$n_1$ und $n_2$ Zahlen von 0 bis 10 und
$n_3$ 0 oder eine Zahl von 1 bis 4,
bedeuten.

5. Durch Strahlung polymerisierbares Gemisch nach Anspruch 1, dadurch gekennzeichnet, daß die polymerisierbare Verbindung als ungesättigte Gruppen Acryl- oder Methacrylsäureestergruppen enthält.

6. Durch Strahlung polymerisierbares Gemisch nach Anspruch 5, dadurch gekennzeichnet, daß als polymerisierbare Verbindung eine Gemisch aus einem Acryl- oder Methacrylsäureester eines zwei- oder mehrwertigen primären Alkohols und einem Polyurethan mit Einheiten der allgemeinen Formel

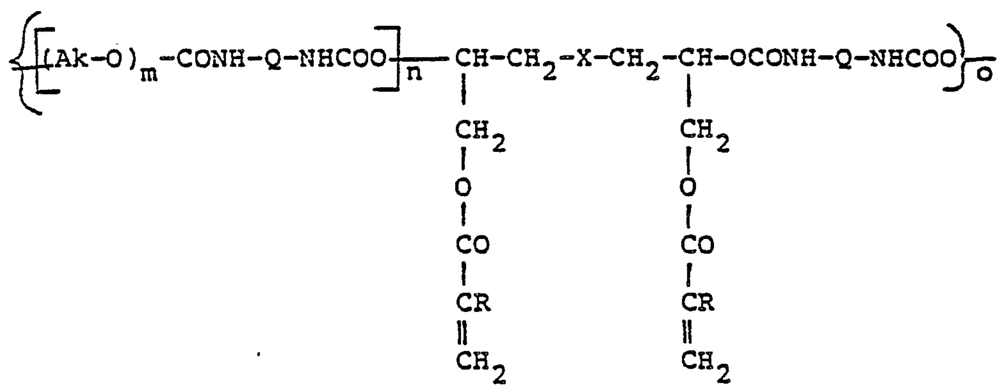

verwendet wird, worin
Q ein zweiwertiger ein- oder zweikerniger aromatischer Rest, der unsubstituiert oder durch niedere Alkylgruppen substituiert ist und der als Bindeglied eine niedere Alkylengruppe enthalten kann,
X eine der Gruppen —O—Ph—X'—Ph—O— und —OOC—$(CH_2)_y$—COO—, wobei Ph eine gegebenenfalls substituierte Phenylengruppe, X' eine Alkylengruppe mit 1-4 Kohlenstoffatomen und y eine Zahl von 2 bis 12 ist,

R ein Wasserstoffatom oder eine Methylgruppe,
AK ein Alkylenrest mit 2-4 Kohlenstoffatomen,
m eine Zahl von 4 bis 50,
n eine Zahl von 1 bis 6 und
o eine Zahl von 4 bis 20 ist.

7. Durch Strahlung polymerisierbares Gemisch nach Anspruch 1, dadurch gekennzeichnet, daß das polymere Bindemittel wasserunlöslich und in wäßrig-alkalischen Lösungen löslich oder mindestens quellbar ist.

8. Durch Strahlung polymerisierbares Gemisch nach Anspruch 1, dadurch gekennzeichnet, daß es zusätzlich zwei Farbstoffe enthält, von denen der eine bei Bestrahlung seine Farbe ändert und bei Temperaturen oberhalb 200 °C unter Entfärbung zerstört und der andere bei Bestrahlung und bei Temperaturen oberhalb 200 °C nicht verändert wird.

9. Photopolymerisierbares Kopiermaterial mit einem flexiblen transparenten temporären Schichtträger und einer übertragbaren thermoplastischen photopolymerisierbaren Schicht, die

a) eine Verbindung mit mindestens zwei endständigen ethylenisch ungesättigten Gruppen, die durch radikalisch initiierte Additionskettenpolymerisation ein vernetztes Polymerisat zu bilden vermag,
b) ein polymeres Bindemittel und
c) einen Photopolymerisationsinitiator

enthält, dadurch gekennzeichnet, daß die Schicht zusätzlich

d) eine Verbindung mit zwei Epoxygruppen im Molekül und einem Molekulargewicht von nicht mehr als 1 500 enthält.

## Claims

1. A radiation-polymerizable mixture containing

a) a compound which has at least two terminal ethylenic-ally unsaturated groups and which can form a crosslinked polymer by means of chain polymerization by addition which is initiated by free radicals,
b) a polymeric binder and
c) a polymerization initiator which can be activated by radiation, characterized in that it contains in addition
d) a compound which has two epoxy groups in the molecule and a molecular weight of no more than 1,500.

2. A radiation-polymerizable mixture which contains the compound having two epoxy groups in a quantity of 1.5 to 10 % by weight.

3. A radiation-polymerizable mixture as claimed in claim 1 wherein the compound having two epoxy groups is a bis-glycidyl ether of a dihydric alcohol or phenol.

4. A radiation-polymerizable mixture as claimed in claim 3 wherein the compound having two epoxy groups corresponds to the general formula

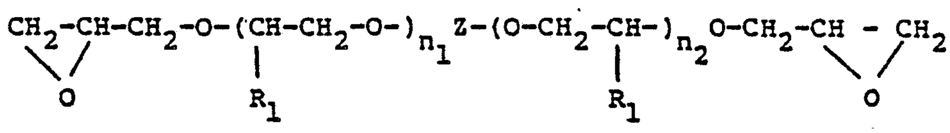

in which Z denotes an alkylene or hydroxyalkylene group having 2 to 6 carbon atoms or a group

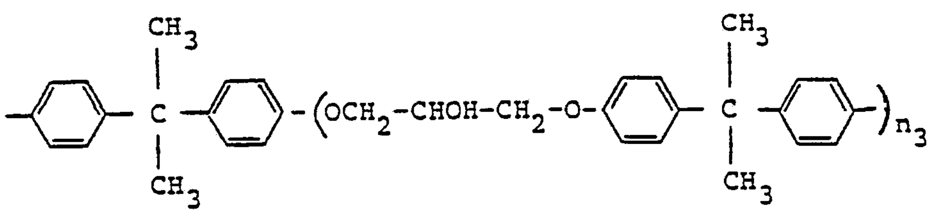

$R_1$ denotes a hydrogen atom or a methyl group $n_1$ and $n_2$ denote numbers from 0 to 10 and $n_3$ denotes 0 or a number from 1 to 4.

5. A radiation-polymerizable mixture as claimed in claim 1 wherein the polymerizable compound contains acrylate or methacrylate groups as unsaturated groups.

6. A radiation-polymerizable mixture as claimed in claim 5 wherein the polymerizable compound used is a mixture of an acrylate or methacrylate of a dihydric or polyhydric primary alcohol and a polyurethane of the general formula

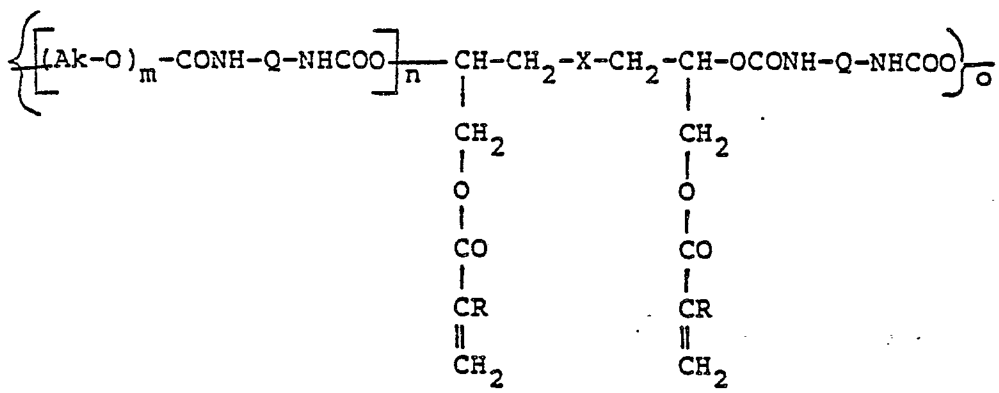

in which Q is a bivalent mononuclear or binuclear aromatic radical which is unsubstituted or substituted by lower alkyl groups and which can contain a lower alkylene group as a connecting member X is one of the groups —O—Ph—X'—Ph—O— and —OOC—$(CH_2)_y$—COO—, in which Ph is an optionally substituted phenylene group.

X' is an alkylene group having 1-4 carbon aotms and y is a number from 2 to 12, R is a hydrogen atom or a methyl group Ak is an alkylene radical having 2-4 carbon atoms m is a number from 4 to 50, n is a number from 1 to 6, and 0 is a number from 4 to 20.

7. A radiation-polymerizable mixture as claimed in claim 1, wherein the polymeric binder is water-insoluble and soluble or at least swellable in aqueous-alkaline solutions.

8. A radiation-polymerizable mixture as claimed in claim 1 which additionally contains two dyestuffs of which one changes its color on irradiation and is destroyed at temperatures above 200 °C with loss of color and the other is not changed on irradiation and at temperatures above 200 °C.

9. A photopolymerizable copying material having a flexible transparent temporary support and a transferable thermoplastic photopolymerizable layer containing

a) a compound which has at least two terminal ethylenic-ally unsaturated groups and which can form a crosslinked polymer by means of chain polymerization by addition which is initiated by free radicals,

b) a polymeric binder and

c) a photopolymerization initiator characterized in that the layer additionally contains

d) a compound which has two epoxy groups in the molecule and a molecular weight of no more than

**Revendications**

1. Mélange polymérisable par irradiation, contenant :

a) un composé avec au moins deux groupes à insaturation éthylénique situés en bout de chaîne, qui peut former un polymère réticulé par polymérisation en chaîne par addition par un mécanisme radicalaire,

b)un liant polymère et

c) un initiateur de polymérisation activable par irradiation, caractérisé en ce qu'il contient en outre :

d) un composé ayant dans sa molécule deux groupes époxy et ayant un poids moléculaire ne dépassant pas 1 500.

2. Mélange polymérisable par irradiation, caractérisé en ce que le composé possédant deux groupes époxy y est contenu en quantité de 1,5 à 10 % en poids.

3. Mélange polymérisable par irradiation selon la revendication 1, caractérisé en ce que le composé possédant deux groupes époxy est un bisglycidyléther d'un dialcool ou d'un diphénol.

4. Mélange polymérisable par irradiation selon la revendication 3, caractérisé en ce que le composé à deux groupes époxy correspond à la formule générale :

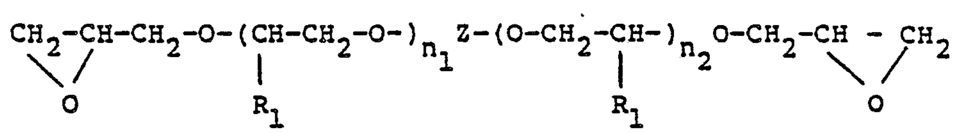

dans laquelle :

Z est un groupe alkylène ou hydroxyalkylène de 2 à 6 atomes de carbone ou le groupe :

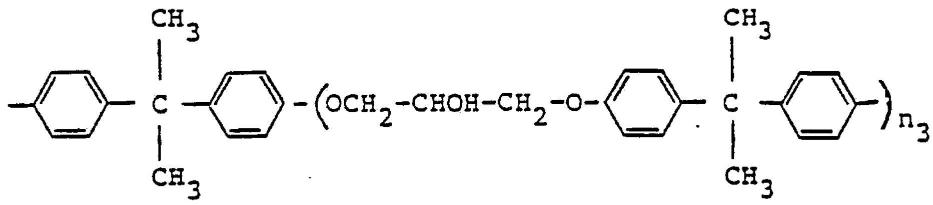

$R_1$ est un atome d'hydrogène ou un groupe méthyle,

$n_1$ et $n_2$ sont des nombres de 0 à 10 et

$n_3$ est égal à 0 ou est un nombre de 1 à 4.

5. Mélange polymérisable par irradiation selon la revendication 1, caractérisé en ce que le composé polymérisable contient comme groupe insaturé des groupes ester acrylique ou ester méthacrylique.

6. Mélange polymérisable par irradiation selon la revendication 5, caractérisé en ce que l'on emploie comme composé polymérisable un mélange d'un ester de l'acide acrylique ou de l'acide méthacrylique et d'un dialcool ou polyalcool primaire et d'un polyuréthane comportant des motifs de formule générale :

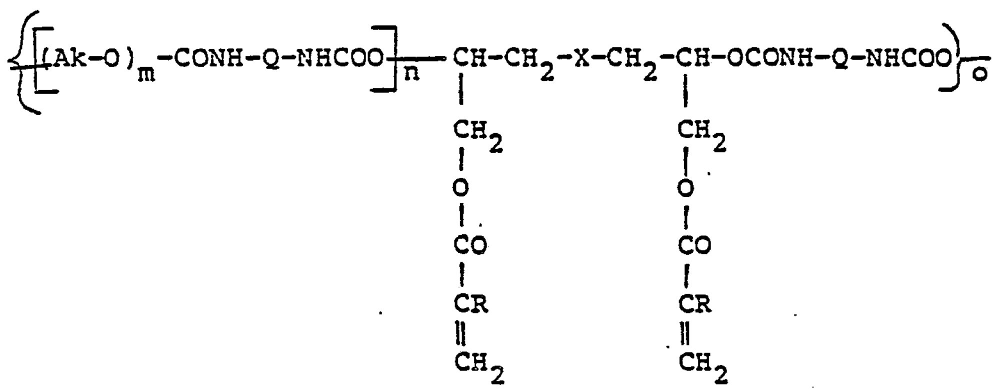

dans laquelle :

Q est un radical aromatique divalent à 1 ou 2 noyaux, qui n'est pas substitué ou qui est substitué par des groupes alkyle inférieurs et qui peut contenir comme élément de liaison un groupe alkylène inférieur,

X est l'un des groupes —O—Ph—X'—Ph—O— et —OOC—$(CH_2)_y$—COO—, où Ph est un groupe phénylène éventuellemnt substitué, X' est un groupe alkylène à 1 à 4 atomes de carbone et Y est un nombre de 2 à 12,

R est un atome d'hydrogène ou un groupe méthyle,

Ak est un radical alkylène à 2 à 4 atomes de carbone,

m est un nombre de 4 à 50,

n est un nombre de 1 à 6 et

o est un nombre de 4 à 20.

7. Mélange polymérisable par irradiation selon la revendication 1, caractérisé en ce que le liant polymère est insoluble dans l'eau et soluble ou du moins gonflable dans les solutions alcalines aqueuses.

8. Mélange polymérisable par irradiation selon la revendication 1, caractérisé en ce qu'il contient en outre deux colorants, dont l'un change de couleur par irradiation et se décompose à des températures supérieures à 200 °C avec décoloration, et l'autre n'est pas modifié par irradiation ni à des températures supérieures à 200 °C.

9. Matériau de reprographie photopolymérisable comportant un support de couche temporaire transparent flexible et une couche photopolymérisable thermoplastique transférable qui contient :

a) un composé ayant au moins deux groupes à insaturation éthylénique situés en bout de chaîne, qui peut former un polymère réticulé par une polymérisation en chaîne par addition initiée par un mécanisme radicalaire.

b) un liant polymère et

c) un initiateur de photopolymérisation, caractérisé en ce que la couche contient en outre :

d) un composé ayant dans sa molécule deux groupes époxy et ayant un poids moléculaire ne dépassant pas 1 500.